# EUROPÄISCHE PATENTSCHRIFT

(11) **EP 1 136 828 B1**
(45) Veröffentlichungstag und Bekanntmachung des Hinweises auf die Patenterteilung: **25.04.2007**
(21) Anmeldenummer: 01106101.7
(22) Anmeldetag: 13.03.2001
(51) Int. Cl.: G01R 19/00

(54) **Verfahren zur Strommessung**
Method for measuring current
Procédé de mesure de courant

(30) Priorität: 20.03.2000 DE 10013537
(43) Veröffentlichungstag der Anmeldung: 26.09.2001
(73) Patentinhaber: Pierburg GmbH, 41460 Neuss (DE)
(72) Erfinder: Stephan, Waldemar, 44319 Dortmund (DE); Katzer, Steffen, 45527 Hattingen (DE); Lelitko, Udo, 58239 Schwerte (DE)
(74) Vertreter: COHAUSZ DAWIDOWICZ HANNIG & SOZIEN

(56) Entgegenhaltungen:
- EP-A- 0 848 259
- US-A- 5 534 763
- US-A- 6 034 493
- TEXAS INSTRUMENTS: "TMS370Cx1x 8-Bit Microcontroller Datasheet" TI TECHNICAL DOCUMENTATION, [Online] Februar 1997 (1997-02), Seite 1 XP002240634 Gefunden im Internet: <URL:http://focus.ti.com/lit/ds/symlink/tm s370c712a.pdf> [gefunden am 2003-05-08]
- JOHNSON J P ET AL: "Review of sensorless methods for brushless DC" INDUSTRY APPLICATIONS CONFERENCE, 1999. THIRTY-FOURTH IAS ANNUAL MEETING. CONFERENCE RECORD OF THE 1999 IEEE PHOENIX, AZ, USA 3-7 OCT. 1999, PISCATAWAY, NJ, USA,IEEE, US, 3. Oktober 1999 (1999-10-03), Seiten 143-150, XP010355155 ISBN: 0-7803-5589-X

## Beschreibung

Die vorliegende Erfindung betrifft ein Verfahren zur Messung der Stromstärke in einem mit einer Steuerelektronik geregelten Elektromotor, der einen Stator mit einer Statorwicklung und einen mit Permanentmagneten bestückten Rotor aufweist, wobei an der Statorwicklung eine externe Versorgungsspannung anlegbar ist und wobei die an eine Statorwicklung angelegte Versorgungsspannung (2) zu einem Zeitpunkt t₀ abgeschaltet wird und nachfolgend die an der Statorwicklung anliegende Spannung gemessen und mit einem vorgegebenen Spannungslevel (8) verglichen.

Ein derartiges Verfahren ist z.B. aus der US-A-6034493 bekannt, wobei nach der Abschaltung auf den Strom in den noch verbliebenen angeschalteten Statorwicklungen geschlossen wird.

Bei derartigen Elektromotoren ist der Wert der Stromstärke eine wichtige Information für die Leistungsregelung oder zur Realisierung einer Überlastabschaltung. Bekanntermaßen wird die Stromstärke in den Statorwicklungen über den Spannungsabfall an einem Widerstand gemessen. Gerade bei besonders kleinen und bei einfach aufgebauten Motoren ist diese Art der Messung nachteilig, da mit den Widerständen zusätzliche Bauteile benötigt werden, die einerseits den Bauraum des Motors vergrößern und andererseits die Herstellungskosten belasten. Zudem wird generell durch jedes zusätzlich benötigte Bauteil die Betriebssicherheit des gesamten Motors verringert. Ähnliche Probleme ergeben sich bei einer anderen Art der Strommessung, bei der der Spannungsabfall über einem Brückentransistor bestimmt wird. Dabei ist zudem nachteilig, daß zur genauen Bestimmung des Stromes eine hohe Auflösung der Spannungsmessung notwendig ist, was mit zusätzlichem technischen Aufwand einhergeht.

Aufgabe der Erfindung ist es daher, ein Verfahren zur Strommessung in Elektromotoren zu schaffen, das eine Reduzierung der Bauteile und damit der Baugröße erlaubt und zu einer Erhöhung der Betriebssicherheit und zu einer Minderung der Herstellungskosten beiträgt.

Diese Aufgabe wird durch ein Verfahren wie in Anspruch 1 beschrieben gelöst.

Der erfindungswesentliche Gedanke liegt darin, daß statt einer absoluten Spannung lediglich ein Zeitintervall zwischen zwei leicht definierbaren Zeitpunkten gemessen wird und daß aus der Länge des Intervalls auf die interessierende Stromstärke zurückgeschlossen wird. Die Vorteile der Erfindung resultieren daraus, daß eine solche Zeitmessung technisch wesentlich einfacher durchzuführen ist, als eine absolute Spannungsmessung. Dabei wird das auszumessende Zeitintervall vom Verlauf der induzierten Spannung definiert, die nach dem Abschalten der Versorgungsspannung in der Statorwicklung auftritt. Aus dem Verlauf der induzierten Spannung kann auf den Verlauf des Stromes und vor allem auf die Stromstärke zum Beginn des Zeitintervalls zurückgeschlossen werden. Die grundlegenden Schritte des erfindungsgemäßen Verfahrens sind die folgenden:

Zu einem Zeitpunkt t₀ wird die an der Statorwicklung anliegende Versorgungsspannung abrupt abgeschaltet. Damit bricht die Spannung in der Statorwicklung zusammen und kehrt ihr Vorzeichen um. Die Stärke dieser induzierten Spannung umgekehrten Vorzeichens hängt dabei von der Größe des Widerstandes der Statorwicklung ab. Die induzierte Spannung nährt sich daraufhin dem Wert Null und überschreitet diesen Wert einerseits wegen des geringen Widerstandes, der eine Dämpfung der Schwingung in mehreren Perioden bewirkt, und andererseits wegen der durch den sich drehenden Rotor erzeugten rückinduzierten Spannung (Back ElectroMagnetic Force, BEMF). Die tatsächliche in der Statorwicklung vorhandene Spannung ist somit eine Addition beider Spannungen. In der Zwischenzeit nimmt auch die ursprünglich vorhandene Stromstärke langsam ab. Die Stromstärke wird an dem Punkt zu Null, wo auch die induzierte Spannung zu Null geworden ist und wo die Spannung in der Statorwicklung lediglich durch die BEMF gebildet wird. Da die Stromstärke exponentiell abgefallen ist, läßt sich aus dem Zeitintervall zwischen dem Abschalten der Spannung und dem Nulldurchgang der induzierten Spannung auf die Stromstärke zum Zeitpunkt der Abschaltung schließen. Diesen Effekt macht sich die Erfindung zunutze.

Wegen des Vorhandenseins der BEMF entspricht der Nulldurchgang der tatsächlich an der Statorwicklung vorhandenen Spannung nicht dem Nulldurchgang der induzierten Spannung, der später erfolgen würde. Aus diesem Grunde und aus Gründen der Praktikabilität wird ein Spannungslevel als Schwelle über der Nullspannung gesetzt, und die Zeit gemessen, bis die Spannung in der Statorwicklung diesen Level überschritten hat. Diese positive Schwelle bildet einen besser zu definierenden und daher besser zu messenden Wert als der Nulldurchgang. Sobald festgestellt wurde, daß der Level überschritten ist, wird die Zeitmessung gestoppt. Die Länge des gemessenen Zeitintervalls, d.h. die Zeit bis zum Erreichen des Levels, ist - wie dargelegt - abhängig von der vor dem Zeitpunkt t₀ herrschenden Stromstärke, wobei eine geringe Korrektur zu berücksichtigen ist.

Die aus dem Verfahren resultierenden Vorteile liegen auf der Hand. So kann einerseits auf die "Shunt"-Widerstände, die zur Messung des Stromes anhand des Spannungsabfalls nötig waren, verzichtet werden. Dieser Verzicht geht mit einer Senkung der Herstellungskosten, einer Reduzierung des Bauraumes und mit einer Erhöhung der Betriebssicherheit einher. Andererseits zeichnet sich das erfindungsgemäße Verfahren durch eine hohe Auflösung und eine große Genauigkeit der Strommessung aus. Damit trägt es zu einer Verbesserung der Regelung und damit zu einer Optimierung der Laufeigenschaften des Motors bei.

Das erfindungsgemäße Verfahren läßt sich bei einer (Block)-Ansteuerung des Elektromotors durch eine Rechteckspannung vorteilhaft einsetzen, da die Rechteckspannung an den Flanken abrupt abbricht und die genannten Effekte ausgenutzt werden können. Hierbei kann zwischen den Pulsen der Rechteckspannung eine spannungslose Totzeit liegen, die länger als ein Meßintervall ist.

Besonders vorteilhaft läßt sich das Verfahren jedoch bei elektronisch kommutierten Gleichstrommotoren einsetzen, die über eine Steuerelektronik mit Leistungshalbleitern verfügen. Bei diesen Motoren läßt sich jede beliebige Spannung durch Pulsweitenmodulation erzeugen. Insbesondere kann die Versorgungsspannung auf einfache Weise abrupt abgeschaltet werden. Es ist möglich, der Versorgungsspannung einen harmonischen Verlauf insbesondere den Verlauf einer Sinusspannung zu geben, und die Versorgungsspannung zum Zeitpunkt t₀ für die Dauer eines Meßintervalls Δt zu unterbrechen.

Es ist zudem vorteilhaft, daß der vorhandene Mikroprozessor mit seinem Taktgeber benutzt werden kann, um die Zeit zu messen und das Überschreiten des Spannungslevels festzustellen. Der Mikroprozessor kann auch die Umrechnung von der Länge des Zeitintervalls zur Stromstärke anhand einer Funktion oder einer Tabelle vornehmen. Das Ausmessen des Zeitintervalles geschieht vorteilhafter Weise durch Zählen von hochfrequenten Pulsen, wobei die Pulse insbesondere eine Frequenz von 1 bis 5 MHz aufweisen. Auch ohne Verwendung der Taktfrequenz eines Mikroprozessors lassen sich einfache und preiswerte Counter/Timer Bausteine in die Steuerelektronik von Elektromotoren integrieren.

Es ist wegen der besonders guten Laufeigenschaften des Motors vorteilhaft, diesen zum Betrieb einer Kreiselpumpe einzusetzen. Wegen der geringen Kosten und der geringen Baugröße läßt sich diese Pumpe besonders gut zum Betrieb von Heiz- oder Kühlkreisläufen insbesondere in Kraftfahrzeugen einsetzen.

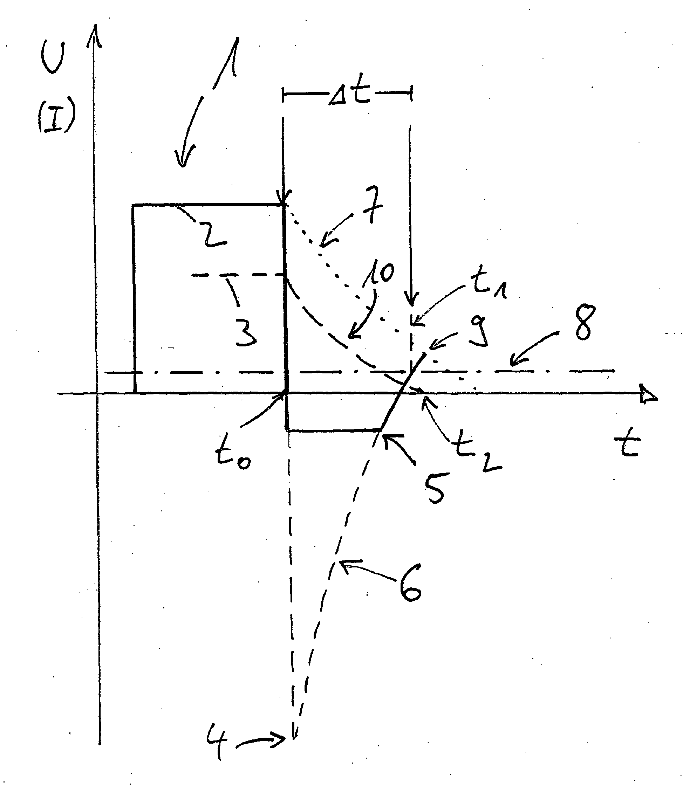

Eine besondere Ausführungsform des erfindungsgemäßen Verfahrens wird anhand der Figur nachfolgend näher beschrieben.

In der Figur ist der Verlauf der an einer Statorwicklung anliegenden Spannung U (durchgezogene Linie) 2 und des entsprechenden Stromes I (unterbrochene Linie) 3 gegen die Zeit t in einem Diagramm aufgetragen. Dargestellt ist ein Spannungspuls 1, wie er bei einer Blockansteuerung an der Statorwicklung eines elektronisch kommutierten Gleichstrommotors generierbar ist. Die anliegende Spannung 2 wird zum Zeitpunkt t₀ unterbrochen die Spannung 2 fällt abrupt ab und kehrt ihr Vorzeichen um. Die Höhe 4 der negativen Spannung ist bedingt durch den Widerstand in der Statorwicklung. Um eine Überspannung zu vermeiden wird die Spannung durch eine Diode auf einen Wert 5 beschränkt. Zum Zeitpunkt wird t₀ die Zeitmessung gestartet.

Nachdem die Spannung 2 in der Statorwicklung ihr negatives Maximum 4 erreicht hat, steigt sie entlang der Kurve 6 wieder an. Dabei ist zu beachten, daß der dargestellte Verlauf der an der Statorwicklung tatsächlich anliegenden Spannung die Summe aus der induzierten und der durch den sich drehenden Rotor rückinduzierten Spannung 7 ist.

Nach dem Startzeitpunkt t₀ wird die an der Statorwicklung liegende Spannung zumindest insofern beobachtet, als ihr Überschreiten über eine vorgegebene Schwelle 8, die in diesem Falle im positiven Bereich liegt, registriert wird. Zum Zeitpunkt t₁ des Übertrittes wird die Zeitmessung gestoppt und die Länge des Intervalls Δt registriert. Dabei stimmt der Zeitpunkt t₁ nahezu mit dem vollständigen Abfall des Stromes I zum Zeitpunkt t₂ überein, der dem Zeitpunkt entspricht, an dem die tatsächlich in der Statorwicklung induzierte Spannung den theoretischen Verlauf der BEMF 7 am Punkt 9 schneidet.

Mit der Kenntnis des exponentiellen Stromabfalls 10 wird aus dem Zeitintervall Δt die ursprüngliche Stromstärke 3 ermittelt.

## Patentansprüche

1. Verfahren zur Messung der Stromstärke in einem mit einer Steuerelektronik geregelten Elektromotor, der einen Stator mit einer Statorwicklung und einen mit Permanentmagneten bestückten Rotor aufweist, wobei an der Statorwicklung eine externe Versorgungsspannung anlegbar ist und wobei die an die Statorwicklung angelegte Versorgungsspannung (2) zu einem Zeitpunkt t₀ abgeschaltet wird und nachfolgend die an der Statorwicklung anliegende Spannung gemessen und mit einem vorgegebenen Spannungslevel (8) verglichen wird, **dadurch gekennzeichnet, daß**
zur Ermittlung der Stromstärke (3) zum Zeitpunkt t₀ ein Zeitintervall Δt gemessen wird, das zwischen dem Zeitpunkt t₀ und einem Zeitpunkt t₁ liegt, bei dem die in der Statorwicklung vorhandene Spannung, die aus der Addition der aufgrund der Abschaltung der Statorwicklung induzierten und der aufgrund der Rotordrehung rückinduzierten Spannung gegeben ist, den vorgegebenen Spannungslevel überschreitet,
wobei aus der Kenntnis des exponentiellen Stromabfalls die Stromstärke (3) zum Zeitpunkt t₀ aus der Länge des gemessenen Zeitintervalles Δt bestimmt wird.

2. Verfahren nach Anspruch 1,
**dadurch gekennzeichnet, daß** dem Zeitintervall eine Stromstärke (3) zugeordnet wird.

3. Verfahren nach Anspruch 1 oder 2,
**dadurch gekennzeichnet, daß** der Elektromotor ein elektronisch kommutierter Gleichstrommotor ist.

4. Verfahren nach einem der vorherigen Ansprüche,
**dadurch gekennzeichnet, daß** die Länge des Zeitintervalls Δt durch Zählen von hochfrequenten Pulsen gemessen wird.

5. Verfahren nach einem der vorherigen Ansprüche,
**dadurch gekennzeichnet, daß** der Spannungslevel (8) auf einen Wert gelegt wird, der in Bezug auf die abgeschaltete Versorgungsspannung (2) dasselbe Vorzeichen hat.

6. Verfahren nach einem der vorherigen Ansprüche,
**dadurch gekennzeichnet, daß** die Versorgungsspannung (2) den Verlauf einer Sinusspannung hat, der zum Zeitpunkt t₀ für ein Meßintervall unterbrochen wird.

7. Verfahren nach einem der vorherigen Ansprüche,
**dadurch gekennzeichnet, daß** die Versorgungsspannung (2) von Pulsen mit abfallender Flanke insbesondere von rechteckigen Pulsen gebildet wird, wobei zwischen den Pulsen eine spannungslose Totzeit liegt, die länger als ein Meßintervall ist.

8. Verfahren nach einem der vorherigen Ansprüche,
**dadurch gekennzeichnet, daß** die Zuordnung von Zeitintervall und Stromstärke anhand einer Funktion oder einer Tabelle vorgenommen wird.

9. Verfahren nach Anspruch 8,
**dadurch gekennzeichnet, daß** die Zuordnung von einem Mikroprozessor vorgenommen wird, der Teil einer Steuerelektronik des Elektromotors ist.

10. Verfahren nach einem der vorherigen Ansprüche,
**dadurch gekennzeichnet, daß** mit dem Elektromotor eine Kreiselpumpe betrieben wird.

## Claims

1. A method for measuring current intensity in an electric motor which is controlled with control electronics and which exhibits a stator with a stator winding and a rotor fitted with permanent magnets, wherein an external supply voltage may be applied to the stator winding and wherein the supply voltage (2) applied to the stator winding is switched off at a time t₀ and the voltage applied to the stator winding is then measured and compared with a predetermined voltage level (8), **characterised in that**
a time interval Δt is measured for determining the current intensity (3) at time t₀, which interval lies between time t₀ and time t₁, where the voltage present in the stator winding, which is obtained by adding together the voltage induced due to the disconnection of the stator winding and reduced due to the rotor rotation, exceeds the predetermined voltage level,
wherein the current intensity (3) at time t₀ is determined from the length of the measured time interval Δt based on a knowledge of the exponential current drop.

2. The method according to Claim 1,
**characterised in that** a current intensity (3) is assigned with the time interval.

3. The method according to Claim 1 or 2,
**characterised in that** the electric motor is an electronically commutated direct current motor.

4. The method according to one of the preceding claims,
**characterised in that** the length of the time interval Δt is measured by counting high frequency pulses.

5. The method according to one of the preceding claims,
**characterised in that** the voltage level (8) is set to a value which has the same sign in relation to the disconnected supply voltage (2).

6. The method according to one of the preceding claims,
**characterised in that** the supply voltage (2) has the course of a sine voltage which is interrupted at the time t₀ for one measuring interval.

7. The method according to one of the preceding claims,
**characterised in that** the supply voltage (2) is formed by pulses with a negative-going edge, particularly square wave pulses, wherein there is a no-voltage dead time between the pulses that is longer than one measuring interval.

8. The method according to one of the preceding claims,
**characterised in that** the time interval and current intensity are assigned by means of a function or table.

9. The method according to Claim 8,
**characterised in that** a microprocessor is assigned which forms part of the control electronics of an electric motor.

10. The method according to the preceding claims,
**characterised in that** a centrifugal pump is operated with the electric motor.

## Revendications

1. Procédé pour mesurer l'intensité du courant dans un moteur électrique qui est régulé par un système électronique de commande et qui comprend un stator avec un bobinage et un rotor muni d'aimants permanents, dans lequel une tension d'alimentation externe peut être appliquée au bobinage du stator et dans lequel la tension d'alimentation (2) appliquée au bobinage du stator est coupée à un moment t₀ et ensuite la tension qui est présente sur le bobinage du stator est mesurée et est comparée à un niveau de tension de consigne (8), **caractérisé en ce que**, pour déterminer l'intensité du courant (3) au moment t₀, on mesure un intervalle de temps Δt qui se situe entre un moment t₀ et un moment t₁ auquel la tension qui est présente dans le bobinage du stator, laquelle est déterminée par l'addition de la tension induite par le fait de la coupure du bobinage du stator et de la tension qui est induite à nouveau par le fait de la rotation du rotor, dépasse le niveau de tension de consigne, l'intensité du courant (3) au moment t₀ étant, à partir de la connaissance de la chute exponentielle du courant, déterminée sur la base de la longueur de l'intervalle de temps mesuré Δt.

2. Procédé selon la revendication 1, **caractérisé en ce qu'**à l'intervalle de temps est attribuée une intensité de courant (3).

3. Procédé selon la revendication 1 ou 2, **caractérisé en ce que** le moteur électrique est un moteur à courant continu à commutation électronique.

4. Procédé selon l'une quelconque des revendications précédentes, **caractérisé en ce que** la longueur de l'intervalle de temps Δt est mesurée par un comptage d'impulsions à haute fréquence.

5. Procédé selon l'une quelconque des revendications précédentes, **caractérisé en ce que** le niveau de tension (8) est placé à une valeur qui a le même signe par rapport à la tension d'alimentation coupée (2).

6. Procédé selon l'une quelconque des revendications précédentes, **caractérisé en ce que** la tension d'alimentation (2) est soumise à une évolution qui est celle d'une courbe sinusoïdale et qui est interrompue au moment t₀ pour un intervalle de mesure.

7. Procédé selon l'une quelconque des revendications précédentes, **caractérisé en ce que** la tension d'alimentation (2) est formée par des impulsions à flancs descendants, notamment par des impulsions rectangulaires, un temps mort hors tension plus long qu'un intervalle de mesure se situant entre les impulsions.

8. Procédé selon l'une quelconque des revendications précédentes, **caractérisé en ce que** l'attribution de l'intervalle de temps et de l'intensité du courant a lieu sur la base d'une fonction ou d'un tableau.

9. Procédé selon la revendication 8, **caractérisé en ce que** l'attribution est réalisée par un microprocesseur qui est une partie d'une électronique de commande du moteur électrique.

10. Procédé selon l'une quelconque des revendications précédentes, **caractérisé en ce que** le moteur électrique est utilisé pour actionner une pompe centrifuge.
